# EUROPEAN PATENT APPLICATION

(11) **EP 2 624 315 A1**
(43) Date of publication of application: **07.08.2013**
(21) Application number: 13153776.3
(22) Date of filing: 02.02.2013
(51) Int. Cl.: H01L 31/058, H01L 31/052, H01L 31/042

(54) **Architectural structure for facing at least part of a façade of a building**

(30) Priority: 02.02.2012 IT TO20120086
(71) Applicant: Albasolar S.r.l., 12051 Alba (IT)
(72) Inventor: Marengo, Massimo, 12051 Alba (IT)
(74) Representative: Boggio, Luigi

(57) **Abstract**

The invention relates to an architectural structure (1) for facing at least part of a facade (2) of a building, comprising a plurality of amorphous silicon photovoltaic panels (3) releasably fastened to the facade (2) so as to form a substantially continuous array (4) of photovoltaic panels; the array (4) of photovoltaic panels lying substantially in a plane (P) arranged at a predetermined distance (D) from the facade (2) so as to define, between the array (4) and the facade (2), an interspace (5) through which a fluid flows; the interspace (5) being open on the bottom and at a top portion of the structure (1) outside the facade (2).

## Description

The present invention concerns an architectural facing structure, in particular for facing at least part of a facade of a building.

More specifically, the invention refers to an architectural facing structure for upgrading the facade of a building intended for industrial/commercial activities, which would require surface treatment (sandblasting, painting, etc.) in order to restore, among other things, satisfactory aesthetic characteristics.

The need is frequently felt to carry out upgrading work on one or more facades of a building (for example an industrial facility) in order to restore its original aesthetic characteristics or to adapt them to requirements which have changed over time.

This is the case, for example, of buildings which, over time, undergo a change of use from spaces intended for production to spaces intended to house offices, administration, etc., i.e. to perform a representation function for which it is advantageous and/or desirable to satisfy aesthetic parameters in addition to a series of functional requirements.

On the other hand, these are interventions that can take a long time and entail significant costs which, in practice, represent a loss for the company, since the objectives of upgrading are typically mainly aesthetic, with limited or no functional effects. Furthermore, they are generally interventions that have to be repeated fairly regularly.

The need is therefore felt, in the sector, to provide an architectural structure for facing a facade of a building, which satisfies aesthetic requirements of finish and visual impact and, at the same time, makes significant functional improvements to the building. In particular, in view of the current legislative context, in which initiatives aimed at reducing in general energy consumption and environmental impact are generally valorised and promoted (also in terms of the economic incentives established by the current laws), the need is felt in the sector to provide an architectural structure for facing at least part of a facade of a building which allows aesthetic upgrading of the facade itself, also improving energy efficiency and, where possible, reducing the overall running costs of the building.

The object of the present invention is therefore to provide an architectural facing structure which simply and inexpensively meets at least one of the above-mentioned needs.

The above-mentioned object is achieved by the present invention, which relates to an architectural facing structure as defined in claim 1.

For a better understanding of the present invention, a preferred embodiment thereof is described below, purely by way of non-limiting example and with reference to the accompanying figures, in which:
- Figure 1 schematically illustrates a lateral view in section of an architectural facing structure according to the invention;
- Figure 2 schematically illustrates a front view of the architectural structure of Figure 1; and
- Figure 3 schematically illustrates a perspective view of a portion of a building used as a production space (industrial) faced by means of the architectural structure of Figures 1 and 2.

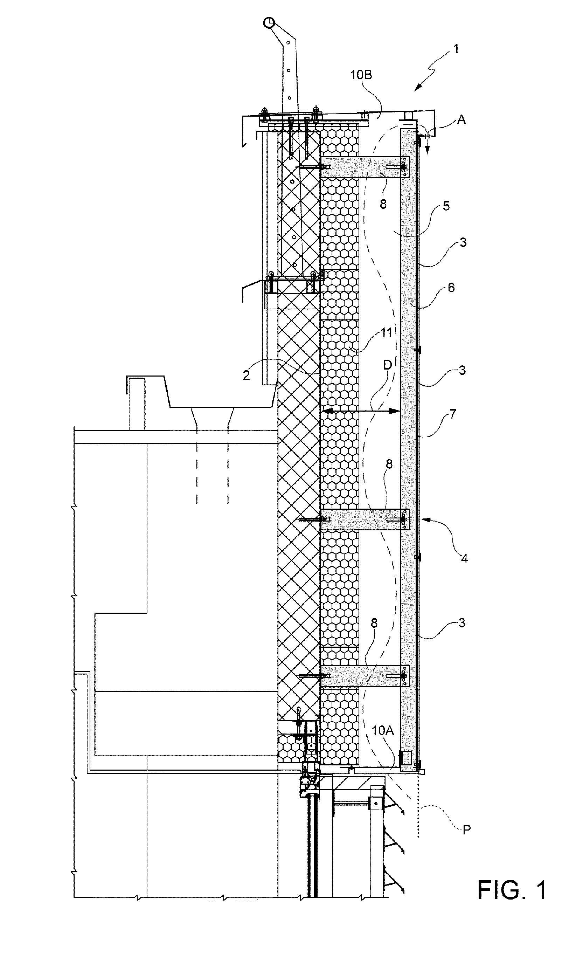

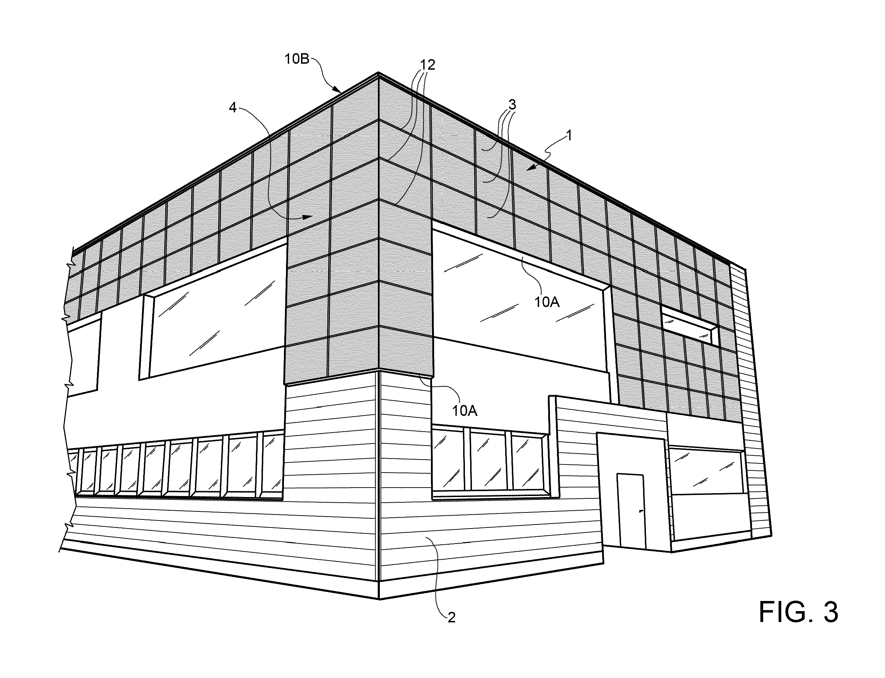

In Figures 1 to 3 an architectural structure for facing at least part of a facade 2 of a building is indicated overall by 1.

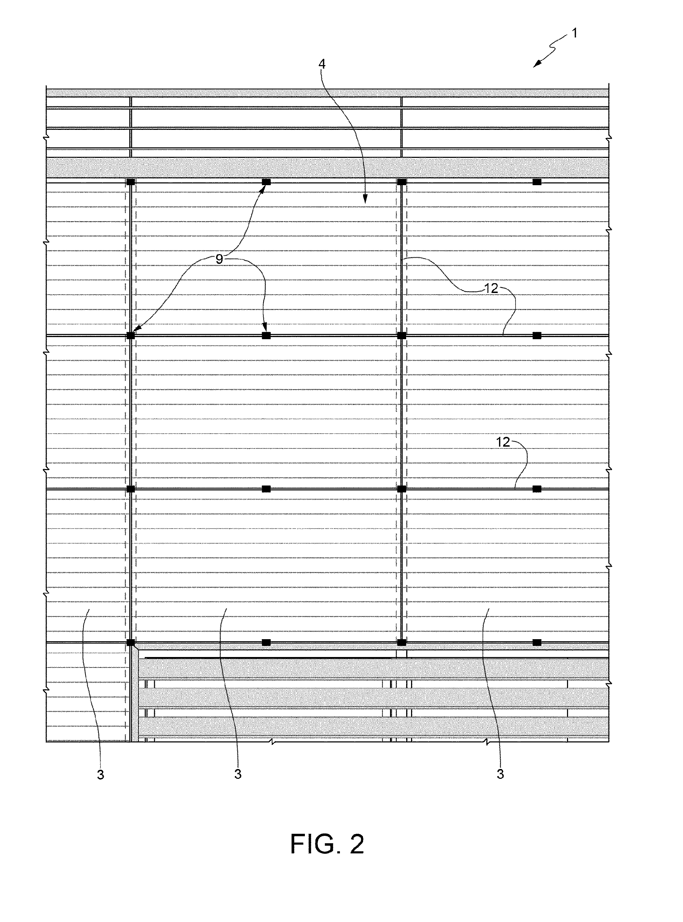

Advantageously, the architectural facing structure 1 comprises (see, in particular, Figures 1 and 2) a plurality of amorphous silicon photovoltaic panels 3 releasably fastened to the facade 2 so as to form a substantially continuous array 4 of photovoltaic panels 3; the array 4 of panels substantially lying in a plane P arranged at a predetermined distance D from the facade 2 so as to define, between the array 4 and the facade 2, an interspace 5 through which a fluid may flow; the interspace 5 being open on the bottom and at a relative top portion, outside the facade 2.

In particular, the facing structure 1 comprises support means 6 for the panels 3 of the type defining a grid of frames, each of which is adapted to receive a respective panel 3.

Advantageously, the support means 6 of the panels 3 comprise a plurality of box sections 7, for example made of galvanised iron, connected to one another to form the frame. The box sections 7 are connected to the facade 2 by means of fastening elements (brackets) 8, which can also be made of galvanised iron. In turn, the photovoltaic panels 3 are fastened to the box sections 7 of the frame by means of anchoring elements 9, for example made of aluminium (preferably anodised, and painted black, for example).

Preferably, the facing structure 1 furthermore comprises elements for lower covering 10A and upper covering 10B of the interspace 5.

In particular, the lower covering element 10A advantageously consists of a perforated metal sheet, through the openings of which the interspace 5 is fluidly connected at the bottom with the environment outside the facade 2.

On the opposite side, the upper covering element 10B, as in the case illustrated in Figure 1, can be advantageously composed of a substantially C-shaped metal sheet arranged with a first portion adapted to provide the cover of the interspace 5 - which is consequently protected from infiltrations of rainwater, etc. - and a second portion, arranged below the upper portion and perforated in order to, or having dimensions such as to, define at least one opening A which provides the fluid connection of the interspace 5 with the environment outside the facade 2 at an upper portion of the structure 1.

In this way, the lower covering elements 10A and upper covering elements 10B of the interspace 5 complete and finish the structure 1, at the same time allowing the circulation of a flow of air inside the interspace 5 (exemplified in Figure 1 by the broken-line arrow).

The interspace 5 can, per se, perform an insulating function. In this way, the facing structure 1 contributes significantly to energy saving by reducing the cost of heating the building in winter and cooling it in summer.

Advantageously, between the facade 2 and the array 4 of photovoltaic panels, the structure 1 can furthermore comprise a layer 11 of thermal insulating material, for example having thickness ranging from 5 to 20 cm, furthermore increasing the insulating effect and furthermore reducing the costs associated with heating and cooling.

The photovoltaic panels 3 are advantageously of the amorphous silicon type. They are photovoltaic panels which, compared to other solutions on the market, have a lower electrical efficiency but cost much less, to the extent that the cost of installation of the facing structure 1 on a facade of a building can be substantially compared with the cost of painting said facade with a high quality finish.

Each amorphous silicon photovoltaic panel 3 substantially consists of a sheet of transparent glass faced, on one side, with a thin layer of amorphous silicon chemically treated to increase the conductivity thereof. In this way, the glass sheet will have a transparent side which, in use, faces the outside, and an opaque side (consisting of the silicon sheet itself) which will be arranged, in use, towards the facade 2. The silicon sheet is also provided with electrical connectors to convey the energy produced by the panel 3 to the electrical grid or to storage devices, such as batteries, capacitors, etc., which store the electrical charge produced by the panels in order to permit deferred use thereof by the user electrical equipment.

Advantageously, the transparent glass edge that surrounds the amorphous silicon portion of each panel 3 is painted to increase the chromatic uniformity of the structure 1.

The amorphous silicon photovoltaic panels furthermore have a relatively low energy cost - in terms of the energy used to produce the panel - and typically, with regular use, return said quantity of energy in the course of only a few years. During their entire working life, they are able to produce a quantity of energy 10-12 times greater than that used for their production.

Apart from the economic aspects, the main advantage offered by this type of photovoltaic panel is the capacity to produce electrical energy also when there is very little sun and in the presence of diffused light only. The amorphous silicon photovoltaic panels are in fact commonly used also in geographical areas with statistically poor exposure to the sun or in which there are physical obstacles that produce large shadow cones. It has even been estimated that, with respect to the other types of panels, amorphous silicon panels are able to offer, on a cloudy day, 8-15% higher efficiency.

Consequently, the facing structure 1 according to the invention is able to guarantee a significant production of electricity, with a relatively low production cost, also when used for facing the north facade of a building and despite the substantially vertical arrangement of the active surface of the panels 3, conditions in which photovoltaic panels with mono- or polycrystalline silicon cells would provide unsatisfactory energy yields, insufficient to justify the significantly higher cost of the relative installation.

Furthermore, a flow of air outside the building passes through the interspace 5, since it is open at the bottom and at the top, and therefore the array 4 of panels 3 is ventilated at the rear.

In particular, with the increase in the external temperature, a circulation will be created by natural convection of a flow of air from bottom to top, the lower and upper covering elements 10A and 10B defining the air inlet and outlet respectively.

This "chimney effect" is doubly advantageous in terms of energy management. On the one hand, the flow of air produced by the natural convection removes heat from, and consequently reduces the temperature of, the facade 2, directly contributing to maintaining preferable ambient conditions inside the building in the summer. On the other hand, the same flow of air removes heat from, and consequently reduces, the temperature of the array 4 of panels 3.

Since the energy efficiency of the photovoltaic panels tends to drop as temperature increases, the natural circulation of air inside the interspace 5 therefore also has the advantageous effect of limiting the loss of efficiency of the panels 3, in particular in summer.

In visual terms, use of the amorphous silicon photovoltaic panels gives the facing structure 1 according to the invention a monochromatic appearance (substantially black, in this basic version, but a coat of paint could be applied in other colours) giving it an attractive modern look.

Furthermore, the facing structure 1 can comprise a plurality of removable joining elements 12, arranged between the panels 3, for example consisting of strips of silicone-based material. The joining elements 12 have, on the one hand, the function of creating aesthetic continuity between the panels 3 and, on the other, advantageously prevent the accumulation of dust, dirt, etc. between the panels. The laying of said joining elements 12 "flush with the glass" is therefore advantageous with respect to the profiles of the traditional frames which, in an energy production situation, would partly affect efficiency, unless they are periodically cleaned. The silicone-based joining elements 12, therefore, significantly reduce the need for recourse to said maintenance interventions, consequently containing the management costs of the structure.

Since the joining elements 12 and the anchoring elements 9 can be independently removed from the frame 7, when maintenance operations are necessary it is possible, by selectively removing one or more joining elements 12 and/or anchoring elements 9, to intervene selectively also on a single panel 3 without having to disassemble other parts of the structure 1.

The structure 1 furthermore typically comprises means (not illustrated) for electrical connection between the panels 3 and/or to other components of a relative photovoltaic system (not illustrated). Typically, in a photovoltaic system, the single panels are connected to one another in series, and series of panels are, in turn, connected in parallel to one another and with a plurality of other elements for operation of the electricity generation system. In particular, said other elements can comprise, for example:
- an inverter, for stabilising the energy collected and converting it into alternating current and, if necessary, feeding it into the grid;
- protection and control panels, located in compliance with the current regulations between the inverter and the grid fed by the latter; and
- a charge regulator, for stabilising the energy collected and managing it within the system.

Advantageously, the facing structure 1 is used as a component of a photovoltaic installation.

From an examination of the characteristics of the architectural covering structure 1 according to the present invention, the advantages thereof are evident.

In particular, the architectural facing structure 1 according to the invention meets aesthetic requirements of finish and visual impact such as to make the relative installation a quality alternative to a conventional upgrade intervention. At the same time, the facing structure 1 reduces the costs associated with heating/cooling of the building on which it is applied, improving the insulating properties. Furthermore, it provides the building with an additional source of electricity which can be used to directly feed the utilities located therein, or the electricity can be sold.

Furthermore, the current regulations allow a government incentive which comprises an increase in the feed-in tariff in accordance with Ministerial Decree 05/05/2011 Photovoltaic systems integrated with innovative characteristics - SECTION III (which is valid, at the time of filing of this patent application, at least until 31st December 2016) of up to 50% with respect to a normal system installed on a roof, in addition to a bonus contribution for efficient energy use of up to 30% of the basic tariff (see Ministerial Decree 05/05/2011 Photovoltaic systems - SECTION II and Photovoltaic systems integrated with innovative characteristics - SECTION III).

Consequently, with respect to another type of facing (painting, etc.), vis-à-vis substantially the same costs for the upgrade, the installation of the structure 1 according to the invention introduces a series of important advantages in energy terms, in addition to - where established by law - an economic incentive which partly offsets the expenditure.

For a company that needs to upgrade a building used for production, in particular, the facing structure 1 according to the invention is particularly advantageous from several points of view.

Lastly, it is clear that modifications and variations can be made to the system described and illustrated here which do not depart from the scope of protection of the independent claims.

In particular, it is clear that the facing structure 1 can be used not only for upgrading a facade of an existing building but also for the finish of a newly constructed building, and that the intended use of said building is not necessary industrial (for example residential). The facing structure 1 can, in fact, constitute an interesting alternative to the installation of a conventional photovoltaic system (on the roof) and, at the same time, gives the building excellent aesthetic characteristics.

## Claims

1. An architectural structure (1) for facing at least part of a facade (2) of a building, comprising a plurality of amorphous silicon photovoltaic panels (3) releasably fixed to said facade (2) so as to form a substantially continuous array (4) of photovoltaic panels; said array (4) of photovoltaic panels substantially lying in a plane (P) arranged at a predetermined distance (D) from said facade (2) so as to define, between said array (4) and said facade (2), an interspace (5) through which a fluid flows; said interspace (5) being open on the bottom and at a top portion of the structure (1), outside said facade (2); the structure (1) furthermore comprising support means (6) for said panels (3) of the type defining a grid of frames, each of which is adapted to receive a respective panel (3); **characterised in that** said support means (6) comprise a plurality of box sections (7) connected to one another so as to form said grid, said box sections (7) being releasably connected to said facade (2) by means of fastening elements (8), said photovoltaic panels (3) being releasably fastened to said box sections (7) by means of anchoring elements (9).

2. The facing structure according to claim 1, **characterised by** comprising lower (10A) and upper (10B) covering elements of said interspace (5) which define an inlet and an outlet for said flow.

3. The facing structure according to claim 1 or 2, **characterised by** comprising, between said facade (2) and said array (4) of photovoltaic panels, a layer (11) of thermally insulating material.

4. The facing structure according to any of claims 1 to 3, **characterised by** comprising a plurality of removable joining elements (12), arranged between said photovoltaic panels (3).

5. A photovoltaic plant comprising a facing architectural structure (1) according to any of claims 1 to 4.
